# EUROPÄISCHE PATENTSCHRIFT

(11) **EP 2 272 310 B1**
(45) Veröffentlichungstag und Bekanntmachung des Hinweises auf die Patenterteilung: **20.06.2018**
(21) Anmeldenummer: 09726766.0
(22) Anmeldetag: 23.03.2009
(51) Int. Cl.: H05K 1/18, H05K 3/32

(54) **ELEKTRISCHES GERÄT**
ELECTRIC DEVICE
APPAREIL ÉLECTRIQUE

(30) Priorität: 02.04.2008 DE 102008016899
(43) Veröffentlichungstag der Anmeldung: 12.01.2011
(73) Patentinhaber: Continental Automotive GmbH, 30165 Hannover (DE)
(72) Erfinder: GRAF, Oliver, 93053 Regensburg (DE); FISCHER, Georg, 93051 Regensburg (DE); MOTSCH, Hans-Werner, 85049 Ingolstadt (DE)
(86) Internationale Anmeldenummer: PCT/EP2009/053342
(87) Internationale Veröffentlichungsnummer: WO 2009/121739

(56) Entgegenhaltungen:
- WO-A-2007/058045
- DE-B3-102006 033 477
- US-A1- 2003 114 022
- US-A1- 2006 071 325
- US-B1- 6 300 566
- US-B1- 6 483 669

## Beschreibung

Die Erfindung betrifft ein elektrisches Gerät, insbesondere ein mechatronisches Getriebe-, Motor- oder Bremssteuergerät, für ein Kraftfahrzeug.

Elektronische Komponenten eines Steuergeräts in einem Kraftfahrzeug müssen vor Umwelteinflüssen, wie z.B. Feuchtigkeit, geschützt werden. Steuergeräte dienen beispielsweise zur elektronischen Steuerung eines Getriebes in einem Kraftfahrzeug. In jüngster Zeit hat sich ein Trend zur Integration der Steuerelektronik und der zugehörigen Sensorik in das Getriebe ergeben. Dies wird als mechatronisches Getriebesteuergerät bezeichnet. Trends für eine solche "Vor-Ort-Elektronik" gibt es auch in anderen Einsatzbereichen, wie z.B. bei Motorsteuergeräten oder Bremssteuergeräten.

Aus der DE102006033477 ist ein Leiterträger bekannt. Dieser offenbart den Obergriff des Anspruchs 1. Bei mechatronischen Steuergeräten werden in der Regel flexible Leiterplatten, sog. Flexfolien, zur Verteilung von elektrischen Signalen und Strömen eingesetzt. Bei einer flexiblen Leiterplatte ist eine Leiterzugstruktur zwischen zwei flexiblen, nicht leitenden Folien (z.B. aus Polyimid) angeordnet. Die Leiterzugstruktur und die leitenden Folien sind über eine Klebeschicht mechanisch miteinander verbunden. Die Leiterzugstruktur umfasst neben Leiterbahnen Kontaktflecken, über die ein elektrischer Kontakt zu einem Kontaktpartner hergestellt wird. Im Bereich der Kontaktflecken wird die flexible Leiterplatte von einer Seite her geöffnet, indem in eine der beiden Folien entsprechende Aussparungen eingebracht werden. Die freigelegte Metallisierung der Leiterzugstruktur im Bereich des oder der Kontaktflecken ermöglicht eine elektrische Kontaktierung zu einem Kontaktpartner, wie z.B. einem Stanzgitter (auch Leadframe genannt), einem Kontaktstift (Pin) oder einer Kontaktfläche eines Bauelements.

Die Herstellung der elektrischen Verbindung zwischen den Kontaktflecken der Leiterzugstruktur der flexiblen Leiterplatte und Kontaktflächen des Kontaktpartners erfolgt z.B. unter Verwendung einer Laserschweißverbindung. Dabei wird die andere der beiden Folien der flexiblen Leiterplatte im Bereich der Kontaktstelle(n) beschädigt, wodurch die Leiterzugstruktur ungeschützt ist. Wird ein solches Steuergerät nun in einem Getriebe angeordnet, so ist dieses von Öl umspült. Durch kleine Metallpartikel, welche bei der Herstellung des Getriebegehäuses nicht vollständig entfernt wurden sowie durch Abrieb der Zahnräder des Getriebes oder Ölschlamm kann es unter Umständen dazu kommen, dass eine elektrische Verbindung zwischen zwei der nun ungeschützten Kontaktstellen hergestellt wird, wodurch ein Kurzschluss möglich ist. Aufgrund des beschriebenen Herstellungsprozesses kann die Folie der flexiblen Leiterplatte einen Schutz sämtlicher Leitungen und Kontakte gegen im Öl befindliche metallische Partikel nicht bereitstellen.

Es ist daher Aufgabe der vorliegenden Erfindung, ein elektrisches Gerät, insbesondere ein mechatronisches Getriebe-, Motor- oder Bremssteuergerät in einem Kraftfahrzeug, anzugeben, bei welchem ein verbesserter Schutz offener Kontaktstellen gegenüber leitenden Partikeln gewährleistet ist.

Diese Aufgabe wird durch ein elektrisches Gerät mit den Merkmalen des Patentanspruches 1 gelöst. Vorteilhafte Ausgestaltungen ergeben sich aus den abhängigen Patentansprüchen. Ein erfindungsgemäßes elektrisches Gerät umfasst ein elektronisches Bauelement, das zumindest eine elektrische Kontaktfläche zur elektrischen Kontaktierung des Bauelements umfasst. Der Begriff des elektronischen Bauelements ist dabei weit zu fassen. Unter ein elektronisches Bauelement im Sinne der Erfindung fallen nicht nur elektronischen Bausteine, wie z.B. Sensoren oder Aktoren, sondern beispielsweise auch Schaltungsträger.

Das elektrische Gerät umfasst weiter eine flexible Leiterplatte, bei der eine Leiterzugstruktur mit zumindest einem Kontaktflecken und Leiterbahnen zwischen zwei flexiblen, nicht leitenden Folien angeordnet sind, wobei zur Ausbildung einer Kontaktstelle ein jeweiliger Kontaktfleck der flexiblen Leiterplatte mit einer jeweiligen Kontaktfläche des Bauelements elektrisch, insbesondere durch eine Verschweißung, verbunden ist. Eine derartige flexible Leiterplatte ist, wie eingangs bereits erläutert, auch unter dem Begriff einer Flexfolie bekannt. Insbesondere sind die die Leiterzugstruktur einbettenden Folien aus einem flexiblen Kunststoff, insbesondere Polyimid, gefertigt. Eine flexible Leiterplatte unterscheidet sich damit von einer herkömmlichen Leiterplatte durch die Flexibilität sowie den konstruktiven Schichtaufbau.

Ferner umfasst das erfindungsgemäße elektrische Gerät ein Dichtelement, das auf einer dem Bauelement gegenüberliegenden Seite der flexiblen Leiterplatte angeordnet ist und einen durch eine Wandung begrenzten Innenraum aufweist, wobei das Dichtelement mit einem Rand der Wandung an die flexible Leiterplatte gepresst ist, so dass der Rand zumindest eine der Kontaktstellen umgibt.

Bei einem erfindungsgemäßen elektrischen Gerät wird das Problem der erforderlichen Span- und Partikeldichtheit durch das Vorsehen eines Dichtelements gelöst, welches die Herstellung einer elektrischen Verbindung (Kurzschluss) zwischen zwei Kontaktstellen des elektrischen Geräts aufgrund von Spänen oder elektrisch leitenden Fremdkörperpartikeln unterbindet. Dabei weist das erfindungsgemäße elektrische Gerät den Vorteil auf, dass dieses auf einfache und kostengünstige Weise herstellbar ist. Ferner stellt ein erfindungsgemäßes elektrisches Gerät mit einem Dichtelement eine Minimierung der Belastung auf die elektrischen Kontaktstellen sicher. Dadurch kann eine vergleichsweise hohe Lebensdauer der Kontaktverbindungen gewährleistet werden, im Vergleich zu einer nicht span- und partikelgeschützten Ausführung des elektrischen Geräts. Die Wandung ist doppelt ausgebildet und weist eine äußere Seitenwand und eine innere, an den Innenraum angrenzende Seitenwand auf, wobei ein die äußere und die innere Seitenwand verbindender Abschnitt der Wandung den Rand ausbildet. Durch das doppelte Ausbilden der Wandung wird eine erhöhte Stabilität des Dichtelements bereitgestellt. Insbesondere kann eine Querbewegung des Dichtelements relativ zu einer Ebene der flexiblen Leiterplatte gut aufgenommen werden. Darüber hinaus wird ein breiterer Dichtabschnitt, welcher in Kontakt mit der Leiterplatte ist, bereitgestellt, wodurch die Dichtwirkung verbessert ist. Ferner ist in dem Rand zwischen der äußeren Seitenwand und der inneren Seitenwand eine Nut ausgebildet. Dies hat zur Folge, dass der an die flexible Leiterplatte gepresste Rand der Wandung durch zwei von der Nut getrennte Dichtlippen gebildet ist, welche zusammen eine doppelte Barriere für das Durchdringen von Spänen und Partikeln in den Innenraum darstellen.

Zweckmäßigerweise umfasst der Innenraum eine oder mehrere Kammern, welche durch eine jeweilige innere Seitenwand ausgebildet sind, wobei eine jeweilige Kammer zur Abdichtung einer Kontaktstelle vorgesehen ist. Insbesondere bildet die äußere Seitenwand eine die inneren Seitenwände der Kammern umgebende gemeinsame Wandung aus. Durch die äußere Seitenwand ist dabei sichergestellt, dass Späne und/oder Partikel nicht in den Innenraum, d.h. in eine der Kammern, des Dichtelements gelangen können. Durch die jeweiligen inneren Seitenwände wird, sofern sich doch Partikel in einer der Kammern befinden, verhindert, dass sich eine elektrisch leitende Verbindung zwischen zwei Kontaktstellen ausbilden kann. Erreicht wird dies dadurch, dass zwischen jeweiligen Kontaktstellen die jeweiligen inneren Seitenwände der die Kontaktstellen abdichtenden Kammern überwunden werden müssen.

Zur Erzielung einer guten Dichtung sowie geringer belastender und schädigender Einwirkungen auf die elektrischen Kontaktverbindungen ist vorgesehen, das Dichtelement aus einem reversibel deformierbaren Kunststoff, insbesondere aus einem Elastomer, auszubilden.

Es ist weiterhin vorgesehen, das Dichtelement in einem umlaufenden Rahmen aus einem im Wesentlichen nicht deformierbaren Material zu fixieren. Insbesondere soll dabei nur die äußere Seitenwand durch den Rahmen fixiert sein. Hierdurch wird einerseits ein gutes Anliegen des Dichtelements an der flexiblen Leiterplatte erreicht. Andererseits weist das Dichtelement gegenüber dem Rahmen eine gewisse Beweglichkeit auf, so dass Toleranzen ausgeglichen werden können.

In einer weiteren Ausbildung weist der Rahmen eine Mehrzahl an Rastelementen auf, mit denen dieser an einem ersten Gehäusebauteil oder in einer zu dem Rahmen korrespondierenden Aussparung des ersten Gehäusebauteils zerstörungsfrei lösbar befestigt ist. Über den Rahmen wird damit der zur Dichtung notwendige Druck erzeugt, mit dem das Dichtelement gegen die flexible Leiterplatte gepresst ist.

Die Abmaße des Rahmens und der Aussparung sind zweckmäßigerweise derart gewählt, dass der Rahmen in der Aussparung parallel zur Ebene der flexiblen Leiterplatte innerhalb vorgegebener Grenzen beweglich gelagert ist. Hierdurch können Reibkräfte zwischen dem Dichtelement und der flexiblen Leiterplatte vermieden werden, welche zu einer Schädigung der Kontaktstelle oder der Leiterzugstruktur aufgrund von "Scheuern" führen kann.

Insbesondere ist das Dichtelement parallel zur Ebene der flexiblen Leiterplatte relativ zu der flexiblen Leiterplatte fixiert. Bei dieser Ausgestaltung kann das mit der flexiblen Leiterplatte elektrisch und/oder mechanisch gekoppelte Bauelement die Beweglichkeit des Dichtelements steuern. Eine derartige Anordnung wird auch als "voll-schwimmende Dichtung" bezeichnet.

Gemäß einer weiteren Ausgestaltung ist ein im Wesentlichen in der Ebene des Bodens des Dichtelements gelegener Abschnitt des Rahmens allein zur Kraftaufnahme einer senkrecht zur Ebene der flexiblen Leiterplatte wirkende Kraft vorgesehen. Hierdurch kann sich der Boden des Dichtelements senkrecht zu der Ebene des Bodens innerhalb vorgegebener Grenzen bewegen und dadurch Toleranzen im Rahmen der Fertigung ausgleichen. Der Rahmen bzw. die entsprechenden Rahmenabschnitte dienen damit als Auflage für das rahmenfixierte Dichtelement.

Hierbei ist es weiter zweckmäßig, wenn zwischen dem Boden des Dichtelements und dem ersten Gehäusebauteil ein Spalt gegebener Höhe ausgebildet ist. Hierdurch lässt sich eine individuell einstellbare zwei-stufige Anpresskraft des Dichtelements an die flexible Leiterplatte einstellen. Zweistufig ist die Anpresskraft deshalb, da zunächst eine Verformung des Dichtelements in dem Spalt erfolgen kann. Hernach erfolgt eine Verformung des Dichtelements selbst, was aufgrund der flexiblen Eigenschaften des Elastomers ohne Weiteres möglich ist. Dabei kann aufgrund der Spaltbreite und der Querschnittsausbildung und der Materialbeschaffenheit des Dichtelements die Dichtkraft eingestellt werden.

Die zwischen der flexiblen Leiterplatte und dem Dichtelement ausgebildete Dichtung ist zumindest partikeldicht ausgebildet. Dies bedeutet, die Dichtung braucht nicht öl- oder flüssigkeitsdicht ausgebildet zu sein. Durch das vorgeschlagene elektrische Gerät wird jedoch sichergestellt, dass Kurzschlüsse zwischen jeweiligen Kontaktstellen verhindert oder zumindest minimiert sind.

Gemäß einer weiteren konkreten Ausgestaltung ist das Bauelement mit seiner der zumindest einen Kontaktfläche abgewandten Hauptfläche auf einem zweiten Gehäusebauteil befestigt. Hierbei sind das erste und das zweite Gehäusebauteil mechanisch miteinander verbunden.

Insbesondere ist das erfindungsgemäße Gerät zur Befestigung in einem Öl- oder Fluidbad vorgesehen. Das erfindungsgemäße elektronische Gerät kann beispielsweise als elektronisches Getriebesteuergerät, als Motor- oder Bremssteuergerät für den Einsatz in einem Kraftfahrzeug ausgebildet sein.

Die Erfindung wird nachfolgend näher anhand der Zeichnungen erläutert. Es zeigen:
- Fig. 1: eine Querschnittsdarstellung eines Teils eines erfindungsgemäßen elektrischen Geräts,
- Fig. 2: eine Querschnittsdarstellung eines erfindungsgemäßen Dichtelements, welches in einem Rahmen fixiert ist,
- Fig. 3: eine perspektivische Darstellung des in Fig. 2 dargestellten Dichtelements,
- Fig. 4: eine Querschnittsdarstellung des in einem Gehäusebauteil angeordneten Dichtelements,
- Fig. 5: eine weitere Querschnittsdarstellung, welche einen Ausschnitt eines erfindungsgemäßen elektrischen Geräts darstellt, bei dem Kontaktstellen durch das Dichtelement geschützt sind, und
- Fig. 6: eine teilweise perspektivische Darstellung eines weiteren elektrischen Geräts, bei dem das Dichtelement voll-schwimmend gelagert ist.

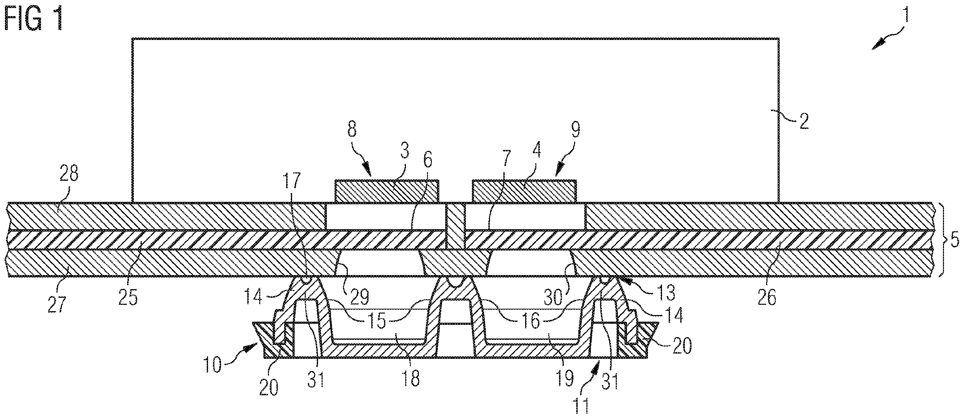

Fig. 1 zeigt eine schematische Querschnittsdarstellung eines Teils eines erfindungsgemäßen elektrischen Geräts 1. Das erfindungsgemäße elektrische Gerät 1 kann z.B. eine mechatronische Getriebesteuerung, eine Motorsteuerung oder eine Bremssteuerung in einem Kraftfahrzeug darstellen. Das elektrische Gerät 1 umfasst ein elektronisches Bauelement 2, z.B. einen Sensor oder ein Halbleiterbauelement. Das Bauelement 2 umfasst im Ausführungsbeispiel zwei Kontaktflächen 3, 4, welche an einer Hauptseite des Bauelements 2 ausgebildet sind. Das Bauelement 2 ist über die Kontaktflächen mit einer flexiblen Leiterplatte 5 elektrisch und mechanisch verbunden. Die flexible Leiterplatte 5 wird als Flexfolie bezeichnet und umfasst eine Leiterzugstruktur mit Leiterbahnen 25, 26 und Kontaktflecken 6, 7. Die Leiterzugstruktur ist zwischen zwei aus isolierendem Material bestehenden Folien 27, 28 angeordnet. Die Kontaktflecken 6, 7 sind durch Einbringen von Öffnungen in die Folie 28 elektrisch zugänglich gemacht. Aufgrund der geringen Dicken der Folien 27, 28 und der gegebenenfalls über die Hauptseite herausstehenden Kontaktflächen 3, 4 ist eine direkte elektrische Kontaktierung der Kontaktflecken mit den korrespondierenden Kontaktflächen 3, 4 möglich.

Die Herstellung einer elektrischen Verbindung zwischen den Kontaktflächen 3, 4 des Bauelements 2 und den Kontaktflecken 6, 7 der Leiterzugstruktur der flexiblen Leiterplatte 5 erfolgt insbesondere durch eine Laserverschweißung. Beim Durchführen des Schweißvorganges von einer dem Bauelement 2 gegenüberliegenden Seite der Leiterplatte 5 her wird im Bereich der herzustellenden Kontaktstellen 8, 9 Energie durch die Folie 27 eingebracht, um den Kontaktflecken 6 mit der Kontaktfläche 3 bzw. den Kontaktflecken 7 mit der Kontaktfläche 4 zu verschweißen. Durch den Energieeintrag in die Folie 27 im Bereich der Kontaktstellen 8, 9 entstehen unbeabsichtigte, aber störende Öffnungen 29, 30 in der Folie 27.

Während die Kontaktstellen 8, 9 von Seiten des Bauelements 2 her konstruktionsbedingt durch das an der Leiterplatte 5 anliegende Bauelement 2 gegen das Eindringen von Partikeln oder Spänen abgedichtet sind, ist die Leiterzugstruktur von der gegenüberliegenden Seite im Bereich der Öffnungen 29, 30 elektrisch zugänglich. Hierdurch bedingt können sich aufgrund der Anordnung des elektrischen Geräts (z.B. in einem Ölbad) Späne oder Partikel, die unter anderem aufgrund von Abrieb mechanischer Komponenten entstehen, an den Kontaktflecken 6, 7 in den Öffnungen 29, 30 anlegen. Unter ungünstigen Umständen kann dabei ein elektrischer Pfad zwischen den Kontaktflecken 6, 7 hergestellt werden. Dadurch kann die Funktionsfähigkeit des elektrischen Geräts beeinträchtigt sein.

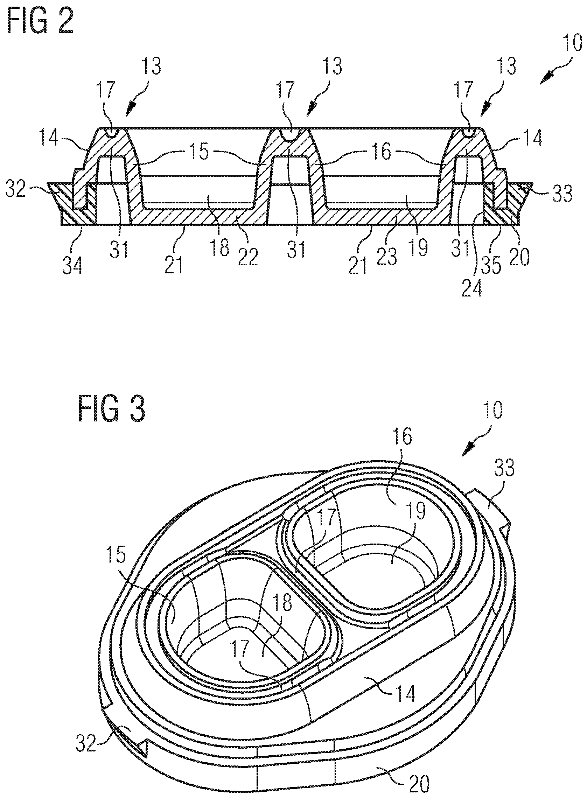

Um das Anlagern von Spänen und/oder Partikeln an die Kontaktflecken 6, 7 im Bereich der Öffnungen 29, 30 der flexiblen Leiterplatte 5 zu vermeiden, ist deshalb ein Dichtelement 10 aus einem reversibel deformierbaren Kunststoff, insbesondere einem Elastomer, vorgesehen. Das Dichtelement 10 allein ist in einer Querschnittsdarstellung in Fig. 2 und in einer perspektivischen Darstellung in Fig. 3 gezeigt. Das Dichtelement 10 weist im Ausführungsbeispiel zwei Kammern 18, 19 auf. Jede Kammer ist, wie besonders gut aus Fig. 3 ersichtlich ist, durch eine innere Wand 15 bzw. 16 und einen Boden 22 bzw. 23 gebildet. Die inneren Seitenwände 15, 16 werden ferner von einer äußeren Seitenwand 14 umgeben. Im Bereich eines an die flexible Leiterplatte 5 angrenzenden Rands 13 des Dichtelements 10 sind die äußere Seitenwand 14 und die inneren Seitenwände 15, 16 jeweils durch einen Materialabschnitt 31 miteinander verbunden. In den Querschnittsdarstellungen der Fig. 1 und 2 ergibt sich damit in dem Rand 13 zwischen der äußeren Seitenwand 14 und den inneren Seitenwänden 15, 16 eine jeweilige Nut 17. Hierdurch bedingt liegt das Dichtelement 16 mit den jeweiligen äußersten Enden der äußeren Seitenwand 14 und der inneren Seitenwände 15, 16 an der flexiblen Leiterplatte 5 an, wobei diese äußerten Enden bzw. Abschnitte Dichtlippen ausbilden.

Gemäß dem in Fig. 1 gezeigten Ausführungsbeispiel ist pro Kontaktstelle 8, 9 jeweils eine Kammer 18, 19 vorgesehen. Hierdurch wird ein optimaler Schutz vor einem Kurzschluss zwischen den Kontaktstellen 8, 9 bereitgestellt. Durch die äußere Seitenwand 14 wird zunächst verhindert, dass Späne und/oder Partikel in dem Ölbad an eine beliebige der Kontaktstellen 8, 9 gelangen können. Hierzu tragen selbstverständlich auch diejenigen Abschnitte der inneren Seitenwände 15, 16 bei, welche im Wesentlichen parallel zu der äußeren Seitenwand 14 verlaufen. Durch das Vorsehen der inneren Seitenwände 15, 16 wird darüber hinaus sichergestellt, dass eventuell im Inneren einer der Kammern 18, 19 vorhandenen Späne und/oder Partikel keinen elektrischen Leiter in Richtung der anderen Kammer und damit der Kontaktstelle bilden können.

In einer von diesem Ausführungsbeispiel abweichenden Ausführungsform könnte jedoch auch vorgesehen sein, dass einer jeweiligen Kammer des Dichtelements mehrere Kontaktstellen zugeordnet sind.

Wie aus den Fig. 1, 2 und 3 gut ersichtlich ist, ist die äußere Seitenwand 14 des Dichtelements 10 mit ihrem der Leiterplatte 5 abgewandten Ende in einem Rahmen 20 fixiert. Der Rahmen 20 ist aus einem im Wesentlichen nicht deformierbaren Material, vorzugsweise Kunststoff gebildet. Der Rahmen 20 weist an zwei gegenüberliegenden Hauptseiten Rastelemente 32, 33 auf, mit welchen der Rahmen und damit das Dichtelement 10 an einem Gehäusebauteil fixiert werden kann. Ferner ist aus den Querschnittsdarstellungen der Fig. 1 und 2 erkenntlich, dass der Rahmen 20 eine Aussparung 24 aufweist. In die Aussparung 24 ragen die Kammern 18, 19 des Dichtelements 10 hinein. Der Boden 21 des Dichtelements bzw. die Böden 22, 23 der Kammern 18, 19 liegen in etwa in einer Ebene mit einer Rahmenunterseite, welche Rahmenauflageabschnitte 34, 35 ausbildet.

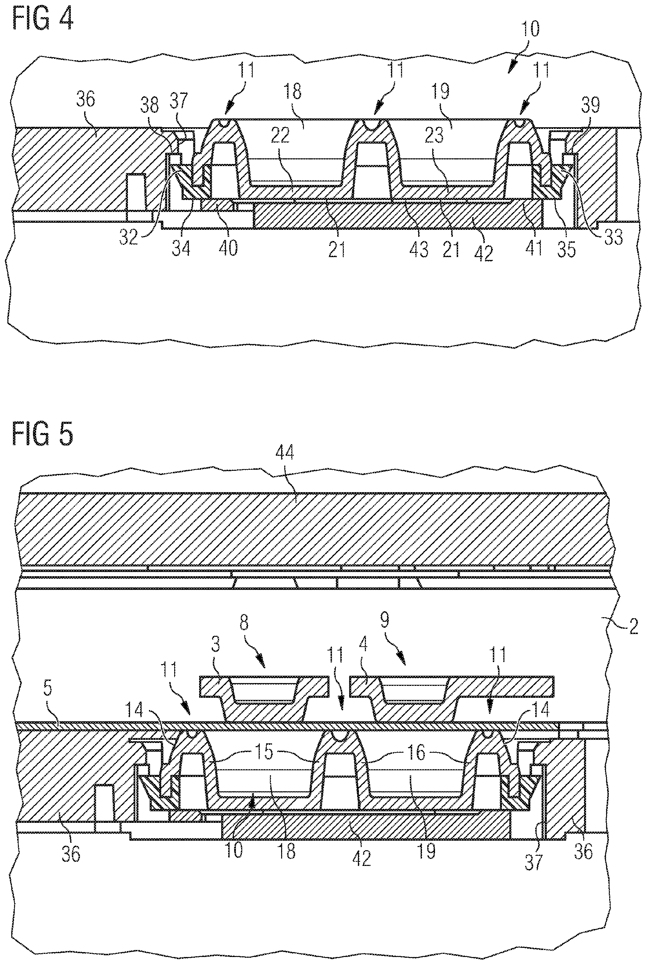

Aus Fig. 4 wird ersichtlich, auf welche Weise das in den Fig. 2 und 3 dargestellte und an dem Rahmen 20 fixierte Dichtelement in einem ersten Gehäusebauteil 36 des elektrischen Geräts 1 angeordnet wird. Das Gehäusebauteil 36 weist eine Aussparung 37 auf, welche mit der Gestalt des Dichtelements 10 bzw. des Rahmens 20 korrespondiert. Die Abmaße des Rahmens 20 und die Abmaße der Aussparung 37 des ersten Gehäusebauteils 36 sind derart gewählt, dass der Rahmen 20 in der Aussparung 37 parallel zur Ebene der flexiblen Leiterplatte innerhalb vorgegebener Grenzen beweglich gelagert ist. Hierdurch wird eine Querbewegung der Dichtlippen, d.h. der an die Leiterplatten angrenzenden Enden der äußeren und inneren Seitenwände 14, 15, 16, verhindert. Hierdurch bedingt treten weniger belastende und schädigende Einwirkungen auf die elektrischen Kontaktverbindungen auf. Der in lateraler Richtung zwischen dem Rahmen 20 und der Aussparung 37 gebildete Spalt ist dabei umlaufend, um ein teilweises "Schwimmen" des Dichtelements 10 zu erzielen.

Beim Einfügen des (mit dem Rahmen 20 versehenen) Dichtelements 10 werden die Rastelemente 32, 33, welche sich nach oben hin erweitern, geringfügig deformiert. Dabei werden die Rastelemente 32, 33 aufeinander zu bewegt. Nach dem Passieren der Engstelle, welche durch Schultern 38, 39 ausgebildet ist, verformt sich der Rahmen 20 im Bereich der Rastelemente 32, 33 zurück. Aufgrund der an dem Rahmen 20 vorgesehenen Rastelemente 32, 33 weist das Dichtelement 10 eine Breite auf, welche größer ist als die Breite der Aussparung 37 an ihrer Oberseite im Bereich der Schultern 38, 39. Hierdurch bedingt ist das Dichtelement 10 über den Rahmen 20 in der Aussparung 37 fixiert, wobei aufgrund eines Spaltes zwischen der Oberkante der Rastelemente 32, 33 und der Schultern 38, 39 ein leichtes Spiel gegeben ist. Mit der Rahmenunterseite, d.h. den Rahmenauflageabschnitten 34, 35 liegt der Rahmen 20 auf Auflageflächen 40, 41 des Gehäusebauteils 36 auf. Zwischen dem Boden 21 des Dichtelements (d.h. den Böden 22, 23 der Kammern 18, 19) und einem Boden 42 der Aussparung 37 ist ein Spalt 43 gebildet, so dass sich das Dichtelement 10 durch Beanspruchung mit geringer Kraft von oben verformen kann, bis der Boden 21 an den Boden 42 der Aussparung 37 anliegt. Eine weitere Kraftbeaufschlagung auf die Wandungen 11 des Dichtelements 10 führt zu einer Verformung der Dichtlippen und der äußeren und inneren Seitenwände 14, 15, 16, wobei sich diese aufgrund ihrer Gestalt nach außen wölben. Durch diese Auslegung kann eine individuell einstellbare zweistufige Anpresskraft auf das Dichtelement eingestellt werden.

Fig. 5 zeigt in einer weiteren teilweisen Querschnittsdarstellung des erfindungsgemäßen elektrischen Geräts die an das Dichtelement 10 angrenzende flexible Leiterplatte 5 mit dem damit verschweißten Bauelement 2. Aus Fig. 5 ist ferner ersichtlich, dass das Bauelement 2 an oder mit einem zweiten Gehäusebauteil 44 befestigt ist. Das erste Gehäusebauteil 36 und das zweite Gehäusebauteil 44 des elektrischen Gerätes 1 sind beispielsweise über eine Rastverbindung oder dergleichen mechanisch miteinander verbunden. Durch die Verbindung des ersten und zweiten Gehäusebauteils 36, 44 wird die flexible Leiterplatte an die Wandungen 11 des Dichtelements 10 gepresst, so dass die erwünschte Dichtigkeit gegenüber dem Durchdringen von Partikeln und/oder Spänen gegeben ist. Je nachdem, mit welcher Kraft die flexible Leiterplatte 5 an das Dichtelement 10 gepresst wird, findet eine Verformung des Dichtelements 10 in Richtung des Bodens 42 der Aussparung 37 statt. Gegebenenfalls findet auch eine Verformung der Wandungen 11 des Dichtelements 10 statt.

Es ist zu betonen, dass durch das erfindungsgemäß vorgesehene Dichtelement keine Dichtung erzielt werden soll, welche das Eindringen von Öl oder einem anderen Fluid in die Kammern 18 oder 19 verhindern soll oder muss. Vielmehr ist es ausreichend, wenn die zwischen der flexiblen Leiterplatte 5 und dem Dichtelement 10 ausgebildete Dichtung partikeldicht ist. Dies beruht auf der Erkenntnis, dass durch eine Vielzahl sich einander berührender Partikel ein elektrisch leitender Pfad bildbar ist, welcher im schlechtesten Fall einen Kurzschluss herbeiführen könnte. Zweck der Dichtung ist somit die Unterbindung eines elektrisch leitenden Pfads zwischen Kontaktstellen der flexiblen Leiterplatte auf der einem Bauelement gegenüberliegenden Seite der flexiblen Leiterplatte.

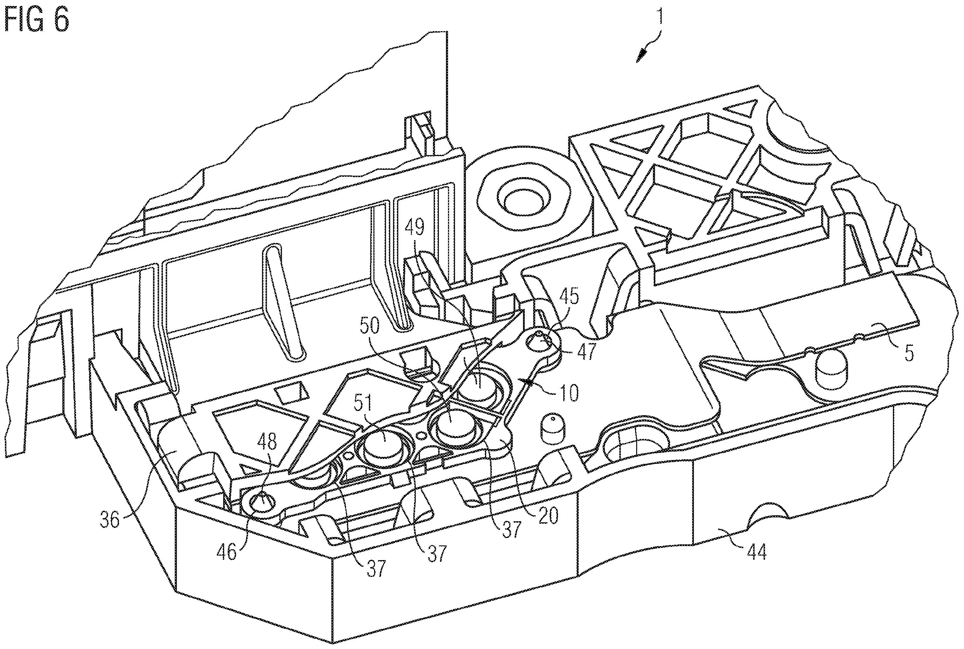

Fig. 6 zeigt ein weiteres Ausführungsbeispiel in einer perspektivischen Darstellung eines Teils eines elektrischen Geräts 1. Dabei ist die Anordnung aus Bauelement 2 (in der Figur nicht sichtbar), flexibler Leiterplatte 5 und Dichtelement 10 zwischen zwei zusammengefügten Gehäusebauteilen 36, 44 angeordnet. Gut zu erkennen aus dieser Darstellung ist die Gestalt des Rahmens 20, welche an gegenüberliegenden äußeren Enden zwei Bohrungen 45, 46 aufweist, in die Stifte 47, 48 des Gehäusebauteils 44 ragen. Die Stifte 47, 48 fixieren hierbei ebenfalls die flexible Leiterplatte 5. Hierdurch kann das an der flexiblen Leiterplatte 5 und dem Gehäusebauteil 44 fixierte Bauteil (in der Figur nicht ersichtlich) die Beweglichkeit des Dichtelements 10 in dem Gehäusebauteil 36 steuern. Um diese Beweglichkeit zu erzielen, ist zwischen dem Rahmen 20 und einer entsprechenden in der Figur nicht dargestellten Aussparung des Gehäusebauteils 44 wiederum ein umlaufender Spalt ausgebildet.

Der Schutz offener Kontaktstellen gegenüber leitenden Partikeln, wie z.B. Spänen und dergleichen, wird im Rahmen der Erfindung durch ein Dichtelement aus einem Elastomer bewirkt. Das Dichtelement ähnelt konstruktiv einer "Balg-Dichtung". Das Dichtelement ist derart ausgebildet, dass eine Einbringung von Axial- und Radialkräften auf die Kontaktstellen vermieden ist. Das Einbringen von Radialkräften wird durch die konstruktive Auslegung des Dichtelements und einer schwimmend gelagerten Verrastung vermieden bzw. minimiert. Die Vermeidung der Einbringung von Axialkräften wird durch die zweistufige Kraftstaffelung in Form der Aussparung des Gehäusebauteils realisiert, in welche das Dichtelement eingebracht wird.

## Patentansprüche

1. Elektrisches Gerät, insbesondere mechatronisches Getriebe-, Motor- oder Bremssteuergerät für ein Kraftfahrzeug, umfassend:
- ein elektronisches Bauelement (2), das zumindest eine elektrische Kontaktfläche (3, 4) zur elektrischen Kontaktierung des Bauelements (2) umfasst;
- eine flexible Leiterplatte (5), bei der eine Leiterzugstruktur mit zumindest einem Kontaktflecken (6, 7) und Leiterbahnen zwischen zwei flexiblen, nicht leitenden Folien (27, 28) angeordnet sind, wobei zur Ausbildung zumindest einer Kontaktstelle (8 ,9) ein jeweiliger Kontaktfleck (6, 7) der flexiblen Leiterplatte (5) mit einer jeweiligen Kontaktfläche (3, 4) des Bauelements (2) elektrisch, insbesondere durch eine Verschweißung, verbunden ist; und
- ein Dichtelement (10), das auf einer dem Bauelement (2) gegenüberliegenden Seite der flexiblen Leiterplatte (5) angeordnet ist und einen durch eine Wandung (11) begrenzten Innenraum aufweist, wobei das Dichtelement (10) mit einem Rand (13) der Wandung (11) an die flexible Leiterplatte (5) gepresst ist, so dass der Rand (13) zumindest eine der Kontaktstellen (8 ,9) umgibt;
- die Wandung (11) doppelt ausgebildet ist und eine äußere Seitenwand (14) und eine innere, an den Innenraum angrenzende Seitenwand (15, 16) umfasst, wobei ein die äußere und die innere Seitenwand (14, 15, 16) verbindender Abschnitt (31) der Wandung (11) den Rand (13) ausbildet;
**dadurch gekennzeichnet, dass** in dem Rand (13) zwischen der äußeren Seitenwand (14) und der inneren Seitenwand (15, 16) eine Nut (17) ausgebildet ist.

2. Gerät nach Anspruch 1, **dadurch gekennzeichnet, dass** der Innenraum eine oder mehrere Kammern (18, 19) umfasst, welche durch eine jeweilige innere Seitenwand (15, 16) ausgebildet sind, wobei eine jeweilige Kammer (18, 19) zur Abdichtung einer Kontaktstelle (8 ,9) vorgesehen ist.

3. Gerät nach Anspruch 2, **dadurch gekennzeichnet, dass** die äußere Seitenwand eine die inneren Seitenwände der Kammern (18, 19) umgebende gemeinsame Wandung (11) ausbildet.

4. Gerät nach einem der vorherigen Ansprüche, **dadurch gekennzeichnet, dass** das Dichtelement (10) aus einem reversibel deformierbaren Kunststoff, insbesondere aus einem Elastomer, gebildet ist.

5. Gerät nach einem der vorherigen Ansprüche, **dadurch gekennzeichnet, dass** das Dichtelement (10) in einem umlaufenden Rahmen (20) aus einem im Wesentlichen nicht deformierbaren Material fixiert ist.

6. Gerät nach Anspruch 5, **dadurch gekennzeichnet, dass** nur die äußere Seitenwand (14) durch den Rahmen (20) fixiert ist.

7. Gerät nach Anspruch 5 oder 6, **dadurch gekennzeichnet, dass** der Innenraum des Dichtelements (10) ferner durch einen Boden (21; 22,23) begrenzt ist und der Rahmen (20) im Bereich des Bodens (21; 22,23) des Innenraums des Dichtelements (10) ausgespart ist.

8. Gerät nach Anspruch 6 oder 7, **dadurch gekennzeichnet, dass** der Rahmen (20) eine Mehrzahl an Rastelementen (32, 33) aufweist, mit denen dieser an einem ersten Gehäusebauteil (36) oder in einer zu dem Rahmen (20) korrespondierenden Aussparung (24) des ersten Gehäusebauteils (36) zerstörungsfrei lösbar befestigt ist.

9. Gerät nach Anspruch 8, **dadurch gekennzeichnet, dass** die Abmaße des Rahmens (20) und der Aussparung (37) derart gewählt sind, dass der Rahmen (20) in der Aussparung (37) parallel zur Ebene der flexiblen Leiterplatte (5) innerhalb vorgegebener Grenzen beweglich gelagert ist.

10. Gerät nach Anspruch 9, **dadurch gekennzeichnet, dass** das Dichtelement (10) parallel zur Ebene der flexiblen Leiterplatte (5) relativ zu der flexiblen Leiterplatte (5) fixiert ist.

11. Gerät nach einem der Ansprüche 6 bis 10, **dadurch gekennzeichnet, dass** ein im Wesentlichen in der Ebene des Bodens (21; 22,23) des Dichtelements (10) gelegener Abschnitt (34, 35) des Rahmens (20) allein zur Kraftaufnahme einer senkrecht zur Ebene der flexiblen Leiterplatte (5) wirkenden Kraft vorgesehen ist.

12. Gerät nach einem der Ansprüche 8 bis 11, **dadurch gekennzeichnet, dass** zwischen dem Boden (21; 22,23) des Dichtelements (10) und dem ersten Gehäusebauteil (36) ein Spalt (43) gegebener Höhe ausgebildet ist.

13. Gerät nach einem der vorherigen Ansprüche, **dadurch gekennzeichnet, dass** die zwischen der flexiblen Leiterplatte (5) und dem Dichtelement (10) ausgebildete Dichtung zumindest partikeldicht ist.

14. Gerät nach einem der vorherigen Ansprüche, **dadurch gekennzeichnet, dass** das Bauelement (2) mit seiner der zumindest einen Kontaktfläche (3, 4) abgewandten Hauptseite auf einem zweiten Gehäusebauteil (44) befestigt ist.

15. Gerät nach Anspruch 14, **dadurch gekennzeichnet, dass** das erste und das zweite Gehäusebauteil (36, 44) mechanisch miteinander verbunden sind.

16. Gerät nach einem der vorherigen Ansprüche, **dadurch gekennzeichnet, dass** dieses zur Befestigung in einem Öl- oder Fluidbad vorgesehen ist.

## Claims

1. Electrical device, in particular mechatronic transmission, engine or brake controller for a motor vehicle, comprising:
- an electronic component (2) which comprises at least one electrical contact area (3, 4) for making electrical contact with the component (2);
- a flexible printed circuit (5) in which a conductor track structure comprising at least two contact pads (6, 7) and conductor tracks are arranged between two flexible, nonconductive films (27, 28), wherein, for the purpose of forming at least one contact point (8, 9), a respective contact pad (6, 7) of the flexible printed circuit (5) is electrically connected, in particular by welding, to a respective contact area (3, 4) of the component (2); and
- a sealing element (10) which is arranged on a side of the flexible printed circuit (5), which side is situated opposite the component (2), and has an interior which is delimited by a wall (11), wherein the sealing element (10) is pressed against the flexible printed circuit (5) by way of an edge (13) of the wall (11), so that the edge (13) surrounds at least one of the contact points (8, 9);
- the wall (11) is of twin design and comprises an outer side wall (14) and an inner side wall (15, 16) which adjoins the interior, wherein a section (31) of the wall (11), which section connects the outer and the inner side wall (14, 15, 16), forms the edge (13);
**characterized in that** a groove (17) is formed in the edge (13) between the outer side wall (14) and the inner side wall (15, 16) .

2. Device according to Claim 1, **characterized in that** the interior comprises one or more chambers (18, 19) which are formed by a respective inner side wall (15, 16), wherein a respective chamber (18, 19) is provided for sealing off a contact point (8, 9).

3. Device according to Claim 2, **characterized in that** the outer side wall forms a common wall (11) which surrounds the inner side walls of the chambers (18, 19).

4. Device according to one of the preceding claims, **characterized in that** the sealing element (10) is formed from a reversibly deformable plastic, in particular from an elastomer.

5. Device according to one of the preceding claims, **characterized in that** the sealing element (10) is fixed in a peripheral frame (20) which is composed of a substantially non-deformable material.

6. Device according to Claim 5, **characterized in that** only the outer side wall (14) is fixed by the frame (20).

7. Device according to Claim 5 or 6, **characterized in that** the interior of the sealing element (10) is further delimited by a base (21; 22, 23) and the frame (20) is cut out in the region of the base (21; 22, 23) of the interior of the sealing element (10).

8. Device according to Claim 6 or 7, **characterized in that** the frame (20) has a plurality of latching elements (32, 33) by way of which the said frame is fastened to a first housing structural part (36) or in a cutout (24) in the first housing structural part (36), which cutout corresponds to the frame (20), such that it can be detached without being destroyed.

9. Device according to Claim 8, **characterized in that** the dimensions of the frame (20) and of the cutout (37) are selected in such a way that the frame (20) is mounted in the cutout (37) such that it can move within prespecified limits parallel to the plane of the flexible printed circuit (5).

10. Device according to Claim 9, **characterized in that** the sealing element (10) is fixed relative to the flexible printed circuit (5) parallel to the plane of the flexible printed circuit (5).

11. Device according to one of Claims 6 to 10, **characterized in that** a section (34, 35) of the frame (20), which section is situated substantially in the plane of the base (21; 22, 23) of the sealing element (10), is provided solely for absorbing a force which acts perpendicular to the plane of the flexible printed circuit (5).

12. Device according to one of Claims 8 to 11, **characterized in that** a gap (43) of a specified height is formed between the base (21; 22, 23) of the sealing element (10) and the first housing structural part (36).

13. Device according to one of the preceding claims, **characterized in that** the seal which is formed between the flexible printed circuit (5) and the sealing element (10) is at least impermeable to particles.

14. Device according to one of the preceding claims, **characterized in that** the component (2) is fastened to a second housing structural part (44) by way of its main side which is averted from the at least one contact area (3, 4).

15. Device according to Claim 14, **characterized in that** the first and the second housing structural part (36, 44) are mechanically connected to one another.

16. Device according to one of the preceding claims, **characterized in that** it is provided for fastening purposes in an oil or fluid bath.

## Revendications

1. Appareil électrique, en particulier un appareil de commande mécatronique de transmission, de moteur ou de freins d'un véhicule automobile, comprenant :
- un composant électronique (2) qui comprend au moins une surface de contact électrique (3, 4) permettant d'établir un contact électrique avec le composant (2) ;
- une carte de circuit imprimé flexible (5), dans laquelle une structure de carte de circuit imprimé comportant au moins un plot de contact (6, 7) et des pistes conductrices sont disposées entre deux films flexibles non conducteurs (27, 28), dans lequel un plot de contact respectif (6, 7) de la carte de circuit imprimé flexible (5) est relié électriquement, en particulier par soudage, à une surface de contact respective (3, 4) du composant (2) afin de former au moins un point de contact (8, 9) ; et
- un élément d'étanchéité (10) qui est disposé sur une face de la carte de circuit imprimé flexible (5) qui est opposée au composant (2) et présente un espace intérieur délimité par une paroi (11), dans lequel l'élément d'étanchéité (10) est comprimé par un bord (13) de la paroi (11) contre la carte de circuit imprimé flexible (5), de sorte que le bord (13) entoure au moins l'un des points de contact (8, 9) ;
- la paroi (11) est réalisée de manière dédoublée et comprend une paroi latérale extérieure (14) et une paroi latérale intérieure (15, 16) adjacente à l'espace intérieur, dans lequel une partie (31) de la paroi (11) reliant les parois latérales extérieure et intérieure (14, 15, 16) forme le bord (13) ; **caractérisé en ce qu'**une rainure (17) est formée dans le bord (13) entre la paroi latérale extérieure (14) et la paroi latérale intérieure (15, 16).

2. Appareil selon la revendication 1, **caractérisé en ce que** l'espace intérieur comprend une ou plusieurs chambres (18, 19) qui sont formées par une paroi latérale intérieure respective (15, 16), dans lequel il est prévu une chambre respective (18, 19) pour étanchéifier un point de contact (8, 9) .

3. Appareil selon la revendication 2, **caractérisé en ce que** la paroi latérale extérieure forme une paroi commune (11) entourant les parois latérales intérieures des chambres (18, 19) .

4. Appareil selon l'une des revendications précédentes, **caractérisé en ce que** l'élément d'étanchéité (10) est constitué d'une matière plastique déformable de manière réversible, en particulier d'un élastomère.

5. Appareil selon l'une des revendications précédentes, **caractérisé en ce que** l'élément d'étanchéité (10) est fixé dans un bâti circonférentiel (20) constitué d'un matériau sensiblement non déformable.

6. Appareil selon la revendication 5, **caractérisé en ce que** seule la paroi latérale extérieure (14) est fixée par le bâti (20).

7. Appareil selon la revendication 5 ou 6, **caractérisé en ce que** l'intérieur de l'élément d'étanchéité (10) est en outre délimité par un fond (21 ; 22, 23) et **en ce que** le bâti (20) est évidé dans la zone du fond (21 ; 22, 23) de l'espace intérieur de l'élément d'étanchéité (10).

8. Appareil selon la revendication 6 ou 7, **caractérisé en ce que** le bâti (20) comporte une pluralité d'éléments d'encliquetage (32, 33) avec lesquels il est fixé de manière amovible à un premier composant de boîtier (36) ou dans un évidement (24) pratiqué dans le premier composant de boîtier (36) et correspondant au bâti (20).

9. Appareil selon la revendication 8, **caractérisé en ce que** les dimensions du bâti (20) et de l'évidement (37) sont choisies de manière à ce que le bâti (20) soit monté mobile dans des limites prédéterminées dans l'évidement (37), parallèlement au plan du circuit imprimé flexible (5).

10. Appareil selon la revendication 9, **caractérisé en ce que** l'élément d'étanchéité (10) est fixé par rapport au circuit imprimé flexible (5) parallèlement au plan du circuit imprimé flexible (5).

11. Appareil selon l'une des revendications 6 à 10, **caractérisé en ce qu'**une partie (34, 35) du bâti (20) située sensiblement dans le plan du fond (21 ; 22, 23) de l'élément d'étanchéité (10) est prévue uniquement pour absorber une force agissant perpendiculairement au plan de la carte de circuit imprimé flexible (5).

12. Appareil selon l'une des revendications 8 à 11, **caractérisé en ce qu'**un interstice (43) ayant une hauteur donnée est formé entre le fond (21 ; 22, 23) de l'élément d'étanchéité (10) et le premier composant de boîtier (36).

13. Appareil selon l'une des revendications précédentes, **caractérisé en ce que** le joint d'étanchéité formé entre la carte de circuit imprimé flexible (5) et l'élément d'étanchéité (10) est au moins étanche aux particules.

14. Appareil selon l'une des revendications précédentes, **caractérisé en ce que** le composant (2) est fixé à un second composant de boîtier (44) dont la face principale est tournée vers l'extérieur de ladite au moins une surface de contact (3, 4) .

15. Appareil selon la revendication 14, **caractérisé en ce que** les premier et second composants de boîtier (36, 44) sont reliés mécaniquement l'un à l'autre.

16. Appareil selon l'une des revendications précédentes, **caractérisé en ce qu'**il est destiné à être fixé dans un bain d'huile ou de fluide.
